# FASCICULE DE BREVET EUROPEEN

(11) **EP 3 657 677 B1**
(45) Date de publication et mention de la délivrance du brevet: **07.01.2026**
(21) Numéro de dépôt: 19209871.3
(22) Date de dépôt: 18.11.2019
(51) Int. Cl.: H03K 17/06

(54) **CIRCUIT D'ALIMENTATION DE COMMANDE D'INTERRUPTEURS**
STROMVERSORGUNGSSCHALTKREIS ZUR STEUERUNG VON SCHALTERN
SWITCH CONTROL SUPPLY CIRCUIT

(30) Priorité: 20.11.2018 FR 1871635
(43) Date de publication de la demande: 27.05.2020
(73) Titulaire: Commissariat à l'Energie Atomique et aux Energies Alternatives, 75015 Paris (FR)
(72) Inventeur: LEFEVRE, Guillaume, 38054 Grenoble Cedex 9 (FR)
(74) Mandataire: Cabinet Beaumont

(56) Documents cités:
- WO-A2-01/52396
- GB-A- 2 324 664
- JOSIFOVIC I ET AL: "SiC JFET switching behavior in a drive inverter under influence of circuit parasitics", POWER ELECTRONICS AND ECCE ASIA (ICPE&ECCE), 2011 IEEE 8TH INTERNATIONAL CONFERENCE ON, IEEE, 30 May 2011 (2011-05-30), pages 1087 - 1094, XP031956255, ISBN: 978-1-61284-958-4, DOI: 10.1109/ICPE.2011.5944659
- IVAN JOSIFOVIC ET AL: "Improving SiC JFET Switching Behavior Under Influence of Circuit Parasitics", IEEE TRANSACTIONS ON POWER ELECTRONICS, INSTITUTE OF ELECTRICAL AND ELECTRONICS ENGINEERS, USA, vol. 27, no. 8, 1 August 2012 (2012-08-01), pages 3843 - 3854, XP011454759, ISSN: 0885-8993, DOI: 10.1109/TPEL.2012.2185951
- YIN SHAN ET AL: "Experimental Comparison of High-Speed Gate Driver Design for 1.2-kV/120-A Si IGBT and SiC MOSFET Modules", IET POWER ELECTRONICS, IET, UK, vol. 10, no. 9, 28 July 2017 (2017-07-28), pages 979 - 986, XP006062452, ISSN: 1755-4535, DOI: 10.1049/IET-PEL.2016.0668
- ANONYMOUS: "DRV421 Integrated Magnetic Fluxgate Sensor for Closed-Loop Current Sensing", 31 March 2016 (2016-03-31), XP055414705, Retrieved from the Internet <URL:http://www.ti.com/lit/ds/symlink/drv421.pdf> [retrieved on 20171011]

## Description

### Domaine technique

La présente description concerne de façon générale les circuits électroniques et plus particulièrement les techniques d'amorçage d'interrupteurs réalisés en technologie MOS. La présente description concerne plus particulièrement les techniques d'alimentation de circuits de commande d'interrupteurs de puissance. La présente description s'applique plus particulièrement aux onduleurs de courant et de tension.

### Technique antérieure

Les onduleurs sont particulièrement répandus. Ils ont en outre connus un développement accru avec l'émergence des installations photovoltaïques.

Les onduleurs de courant sont généralement basés sur l'emploi de transistors MOS de puissance en série entre des bornes d'application d'une tension alternative et commandés cycliquement. La commande requiert d'alimenter des circuits de commande (drivers) de ces transistors à partir de potentiels variables ou flottants. Cela conduit généralement à prévoir des éléments d'isolation galvanique, ce qui accroît le coût de la solution.

Le document WO-A-0152396 décrit un convertisseur de puissance élévateur de tension (boost) à base d'élément inductif de stockage d'énergie.

Le document GB-A-2324664 décrit un circuit de protection contre des défauts de tension négative.

### Résumé de l'invention

Il existe un besoin d'amélioration des circuits d'alimentation de circuit de commande d'interrupteurs de puissance, en particulier dans des applications aux "onduleurs".

Un mode de réalisation pallie tout ou partie des inconvénients des circuits d'alimentation de circuits de commande d'interrupteurs MOS de puissance en série à sources communes de type N.

Un mode de réalisation prévoit une solution particulièrement simple et peu onéreuse par rapport aux solutions actuelles.

Un mode de réalisation prévoit un circuit selon la revendication indépendante 1.

Selon un mode de réalisation, le montage constitue un montage Bootstrap.

Selon un mode de réalisation, une deuxième borne de la source de tension est reliée, de préférence connectée, à une deuxième borne du premier circuit.

Selon un mode de réalisation, le premier circuit et le deuxième circuit sont des circuits de commande respectifs d'un premier interrupteur et d'un deuxième interrupteur en série, les deuxièmes bornes respectives du premier circuit et du deuxième circuit étant reliées, de préférence connectées, à des bornes de conduction respectives du premier interrupteur et du deuxième interrupteur.

Selon un mode de réalisation, ladite perle de ferrite est choisie pour avoir une fréquence de résonance du même ordre de grandeur que la fréquence de commutation des premier et deuxième interrupteurs.

Selon un mode de réalisation, les interrupteurs sont des interrupteurs à commande en tension.

Selon un mode de réalisation, les interrupteurs sont des transistors MOS à canal N montés en sources communes.

Un mode de réalisation prévoit un commutateur comportant un circuit selon l'une quelconque des revendications 1 à 10.

Selon un mode de réalisation, le commutateur comporte en outre :
une deuxième source de tension en série avec la première source de tension, le premier circuit de commande étant alimenté par les deux sources de tension en série ; et
un deuxième montage d'alimentation entre une borne de la deuxième source de tension et une borne du deuxième circuit de commande.

Un mode de réalisation prévoit un onduleur de courant comportant six commutateurs tels que décrits, reliés en série par paire de commutateurs, les paires de commutateurs étant en parallèle entre deux bornes d'entrée de l'onduleur.

Un mode de réalisation prévoit un onduleur de tension comportant des commutateurs tels que décrits.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon très schématique, un exemple d'onduleur de courant usuel ;
la figure 2 représente, de façon très schématique, un mode de réalisation d'un onduleur de courant du type auquel s'appliquent, à titre d'exemple, les modes de réalisation décrits ;
la figure 3 représente un exemple de montage Bootstrap usuel ;
la figure 4 représente un mode de réalisation d'un montage Bootstrap de génération de tensions d'alimentation de circuits de commande de deux transistors en série selon l'invention ;
la figure 5 représente, de façon schématique et partielle, un modèle du montage de la figure 4 ;
la figure 6 représente, de façon schématique et partielle, un autre modèle du montage de la figure 4 ;
la figure 7 représente un schéma électrique équivalent d'une perle de ferrite ;
la figure 8 illustre un exemple de réponse en fréquence d'une perle de ferrite ;
la figure 9 illustre la susceptibilité de la tension de commande d'un transistor du circuit de la figure 4 ; et
la figure 10 représente un autre mode de réalisation d'un montage d'alimentation de circuits de commande de deux transistors en série.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la génération des signaux de commande en modulation de largeur ou de fréquence d'impulsion pour commander les interrupteurs de puissance n'a pas été détaillée, les modes de réalisation décrits étant compatibles avec les techniques usuelles de génération de tels signaux. De même, l'exploitation de l'énergie transférée par les interrupteurs de puissance, dont la commande est assurée par des circuits alimentés par les modes de réalisation décrits, n'a pas été détaillée, les modes de réalisation décrits étant, là encore, compatibles avec les exploitations usuelles.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Pour simplifier, les modes de réalisation décrits prennent pour exemple une application à un onduleur de courant. On notera cependant que ces modes de réalisation se transposent à un onduleur de tension et plus généralement à l'alimentation de circuits de commande d'interrupteurs en série.

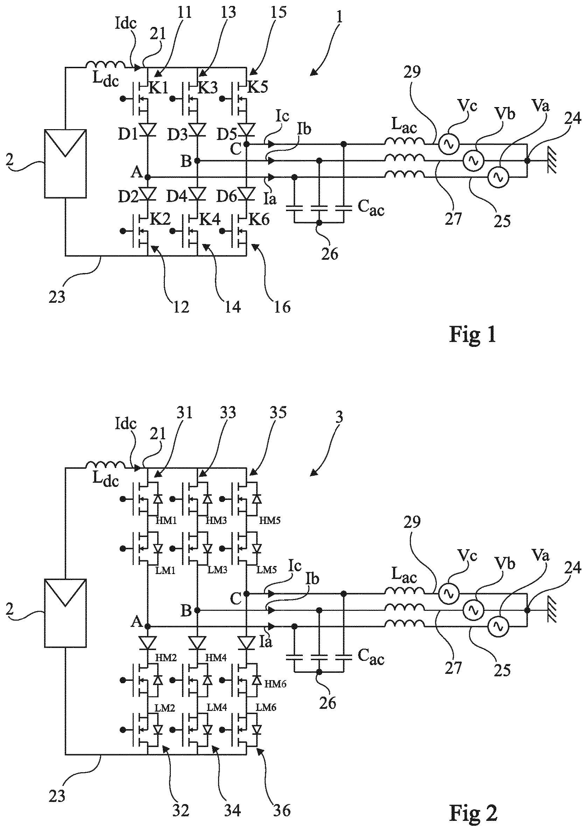

La figure 1 représente, de façon très schématique, un exemple d'onduleur de courant usuel. Dans l'exemple de la figure 1, on considère le cas d'un onduleur triphasé.

Un onduleur de courant 1 du type illustré en figure 1 est basé sur six commutateurs 11, 12, 13, 14, 15 et 16. Les commutateurs sont en série, deux par deux, entre des bornes 21 et 23, de sorte à former trois branches parallèles de deux commutateurs 11-12, 13-14 et 15-16 en série. Une source de tension 2 en série avec une inductance Ldc est reliée entre les bornes 21 et 23. Les commutateurs 11 à 16 sont commandés pour être passants deux à deux (à chaque cycle, un commutateur haut 11, 12 ou 13, d'une branche avec un commutateur bas 12, 14, 16, d'une autre branche) pour découper le courant continu Idc entrant par la borne 21 en trois courants alternatifs Ia, Ib et Ic sur les points milieux respectifs A, B et C des associations en série des paires de commutateurs 11-12, 13-14 et 15-16. Chaque borne A, B, C est reliée, par une inductance Lac, à une borne, respectivement 25, 27, 29, de fourniture d'une tension alternative Va, Vb, Vc par rapport à la masse 24 ou neutre N de l'alimentation alternative. Chaque borne A, B, C est en outre reliée, par un condensateur Cac, à un noeud commun 26 (montage en étoile) tel que cela est représenté en figure 1, ou à une autre des bornes A, B et C (montage en triangle non représenté).

Le fonctionnement d'un onduleur de courant est usuel et ne sera pas détaillé.

Dans la structure de la figure 1, chaque commutateur est constitué d'un interrupteur commandable K1, K2, K3, K4, K5, K6 (typiquement un transistor MOS) en série avec une diode D1, D2, D3, D4, D5, D6. Le rôle des diodes D1 à D6 est de rendre chaque commutateur bidirectionnel en tension (le transistor MOS ou IGBT K bloque une tension positive, la diode D associée bloque une tension négative et un courant circule dans les deux composants quand le transistor K est fermé ou passant (ON) et que la diode D est polarisée en direct).

Dans certaines applications, typiquement des applications basses puissances (inférieures à quelques dizaines de kilowatts), la résistance série des diodes à l'état passant engendre des pertes et des chutes de tension aux bornes des diodes qui sont préjudiciables au rendement de l'onduleur.

La figure 2 représente, de façon très schématique, un mode de réalisation d'un onduleur de courant 3 du type auquel s'appliquent, à titre d'exemple, les modes de réalisation décrits. Dans l'exemple de la figure 2, on considère également le cas d'un onduleur triphasé.

L'architecture générale de l'onduleur est similaire à l'onduleur de la figure 1. On retrouve six commutateurs 31, 32, 33, 34, 35 et 36 en série, deux par deux, entre des bornes 21 et 23 entre lesquelles sont reliées une source de tension 2 en série avec une inductance Ldc. On retrouve également des inductances Lac reliant des points milieux A, B et C des associations en série des paires de commutateurs 31-32, 33-34 et 35-36, à des bornes 25, 27 et 29 de fourniture de tensions alternatives Va, Vb, Vc par rapport à la masse 24 ou neutre N de l'alimentation alternative, et les condensateurs Cac reliant, dans l'exemple représenté, les bornes A, B, C à un noeud commun 26.

Toutefois, dans le mode de réalisation de la figure 2, les diodes sont remplacées par des interrupteurs commandables (ici, des transistors MOS) de façon à disposer de chutes de tension à l'état passant nettement plus faibles (par exemple inférieures à 400 millivolts). Cela revient à monter tête-bêche, dans chaque commutateur, deux interrupteurs bidirectionnels en courant.

Ainsi chaque commutateur comporte un transistor haut HM1, HM2, HM3, HM4, HM5, HM6 en série avec un transistor bas, respectivement LM1, LM2, LM3, LM4, LM5, LM6. Par rapport à l'onduleur de la figure 1, la fonction de blocage de la conduction de la diode intrinsèque des transistors HM1, HM3, HM5, HM2, HM4 et HM6 (représentant les interrupteurs K1, K3, K5, K2, K4 et K6 de la figure 1) est assurée par l'ouverture respective des transistors LM1, LM3, LM5, LM2, LM4 et LM6. En figure 2, on a représenté les diodes intrinsèques des différents transistors.

Une difficulté réside alors dans l'alimentation des circuits de commande des transistors haut HM et bas LM d'un même commutateur. En effet, il faut prévoir un circuit de commande (driver) supplémentaire par commutateur dans la mesure où il y a deux transistors de même nature (ils sont tous les deux typiquement à canal N). Or, ce circuit de commande, s'il n'est pas en soi compliqué, requiert d'être alimenté par rapport à des potentiels variables ou flottants. En particulier, s'agissant de transistors à canal N montés tête-bêche, c'est-à-dire à sources communes, les circuits de commande doivent être alimentés par une tension dont un potentiel est le potentiel de source, donc flottant.

Les techniques usuelles font appel à des circuits à isolation galvanique qui sont particulièrement onéreux.

Les solutions proposées dans la présente description tirent leur origine dans une nouvelle approche, basée sur l'utilisation d'une unique alimentation pour deux interrupteurs (transistors MOS) montés tête-bêche ou à sources communes (pour des transistors à canal N).

On aurait pu penser transposer une technique dite de montage Bootstrap qui se base sur une unique source de tension d'alimentation pour alimenter les circuits de commande des transistors MOS haut et bas. Toutefois, les montages Bootstrap usuels ne sont pas adaptés et ne fonctionnent pas de manière optimale dans un montage de deux transistors MOS tête-bêche.

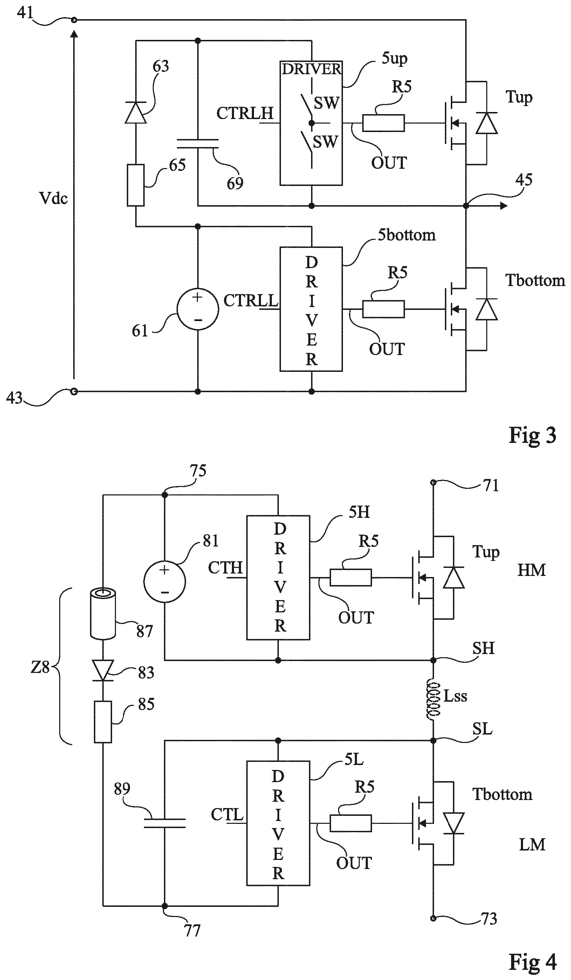

La figure 3 représente un exemple de montage Bootstrap usuel.

Cette figure illustre le principe d'un montage Bootstrap pour alimenter des circuits de commande d'un bras composé de deux transistors MOS Tup et Tbottom en série entre deux bornes 41 et 43 d'application d'une tension continue Vdc. Le point milieu 45 de l'association en série constitue une borne de sortie à destination d'une charge non représentée. Les sources respectives des transistors Tup et Tbottom sont reliées aux bornes 45 et 43. La commande de chaque transistor Tup, Tbottom, est assurée par un circuit (DRIVER) 5up, respectivement 5bottom, dont une borne d'entrée reçoit un signal CTRLH, respectivement CTRLL et dont une borne de sortie OUT est reliée, par une résistance R5, dite de grille, à la grille du transistor Tup, respectivement Tbottom. La résistance R5 permet notamment d'ajuster la dynamique de commutation de l'interrupteur Tup ou Tbottom correspondant et de réduire les oscillations au niveau de leur grille respective. Typiquement, chaque circuit 5up, 5bottom, comporte une structure CMOS de deux interrupteurs SW en série (voir le circuit 5up) dont le point milieu fournit un signal en tout ou rien de commande du transistor Tup ou Tbottom et dont les grilles reçoivent une information représentative du signal de commande associé CTRLH ou CTRLL. Les signaux de commande CTRLH et CTRLL doivent être générés de façon à éviter toute conduction simultanée des transistors Tup et Tbottom qui aurait pour conséquence de mettre la source de tension Vdc en court-circuit.

Dans la mesure où les transistors Tup et Tbottom sont des transistors MOS à canal N, les signaux OUT des circuits 5up et 5bottom doivent être respectivement référencés au potentiel de la borne 45 (pour le circuit 5up) et au potentiel de la borne 43 (pour le circuit 5bottom). Le principe d'un circuit Bootstrap est d'alimenter, sans isolation galvanique, un circuit à potentiel flottant à partir d'une alimentation référencée à un potentiel fixe. Pour cela, un circuit Bootstrap usuel comporte une source 61 de tension continue référencée à la borne 43 alimentant directement le circuit 5bottom et dont la borne positive est reliée, par une diode 63 en série avec une résistance 65, à une borne d'alimentation positive du circuit 5up. Cette borne d'alimentation positive est par ailleurs reliée, par un condensateur 69, à la borne de sortie 45. La source de tension 61 est généralement une source basse tension (de quelques volts) compatible avec les tensions que peuvent supporter les circuits de commande 5up et 5bottom. Un tel circuit fonctionne car les interrupteurs Tup et Tbottom sont commandés pour ne pas être passants en même temps.

Le circuit 5bottom, associé à l'interrupteur Tbottom, peut être commandé directement par la source de tension 61 dans la mesure où il possède une référence commune à cette source de tension. Côté circuit 5up, lorsque l'interrupteur Tbottom est fermé ou passant (ON), la source de tension 61 charge le condensateur 69 positivement par rapport à la borne 45 et crée ainsi une alimentation auxiliaire pour le circuit 5up. La diode 63, conditionnant le sens de circulation de la source 61 vers le condensateur 69, évite que ce condensateur 69 se décharge autrement que pour alimenter le circuit 5up. La diode 63 permet également de bloquer la tension élevée (Vdc majorée de la tension aux bornes du condensateur 69) qui est présente sur sa cathode lorsque le transistor Tbottom est ouvert ou bloqué (OFF), et protège ainsi la source de tension 61. La résistance 65 sert à limiter les courants d'appels lors de la recharge du condensateur 69.

Un tel montage Bootstrap est fortement dépendant des conditions opératoires et notamment du rapport cyclique et de la fréquence des signaux CTRLH et CTRLL. En effet, la charge du condensateur 69 ne s'effectue que pendant les cycles où le transistor Tbottom est fermé.

Un montage Bootstrap tel qu'illustré par la figure 3 n'est donc pas transposable à la génération de tensions d'alimentation pour des circuits de commande d'interrupteurs MOS d'un onduleur de courant tel qu'illustré par la figure 2. Plus généralement, un tel montage n'est pas transposable à la commande d'interrupteurs MOS en série tels qu'ils sont simultanément bloqués et passants. En d'autres termes, il ne se transpose pas à l'alimentation de circuits de commande de deux transistors à sources communes en série entre deux potentiels dont un potentiel variable (le point A, B ou C dans l'exemple de la figure 2).

La figure 4 représente un mode de réalisation d'un montage Bootstrap de génération de tensions d'alimentation de circuits de commande de deux transistors en série, montés tête-bêche.

Selon ce mode de réalisation, on suppose que deux interrupteurs HM et LM (typiquement des transistors MOS, de préférence à canal N montés à sources communes) sont reliés, de préférence connectés, entre deux bornes 71 et 73 d'application d'une tension qui varie dans le temps. En reprenant l'exemple de l'onduleur 3 de la figure 2, et selon le commutateur considéré, la borne 71 est la borne 21 et la borne 73 est l'une des bornes A (commutateur 31), B (commutateur 33) et C (commutateur 35), ou la borne 71 est l'une des bornes A (commutateur 32), B (commutateur 34) et C (commutateur 36) et la borne 73 est la borne 23.

Le transistor HM est commandé par un circuit (DRIVER) 5H et le transistor LM est commandé par un circuit (DRIVER) 5L, des bornes de sortie OUTH et OUTL des circuits 5H et 5L étant reliées, de préférence par des résistances R5, aux grilles respectives des transistors HM et LM. Chaque circuit 5H, 5L reçoit un signal de commande CTH, respectivement CTL. On note que, contrairement aux signaux CTRLH et CTRLL de la figure 3 qui doivent être différents pour les deux circuits 5up et 5bottom, les signaux CTH et CTL ne requièrent aucune propriété particulière, les interrupteurs étant commandés à tout instant par leur source. En figure 4, bien que la connexion l'une à l'autre des sources des transistors HM et LM soit de préférence directe, on a illustré (en pointillés) une inductance parasite Lss reliant l'une à l'autre les sources SH et SL des transistors HM et LM. En effet, dans les applications visées, bien que les deux transistors HM et LM soient passants en même temps, lors des commutations pour les rendre passants ou bloqués, l'inductance parasite Lss de connexion des sources entre-elles est susceptible d'engendrer une différence de potentiel entre les sources SH et SL. Ces tensions induites risquent de perturber le fonctionnement.

Selon le mode de réalisation de la figure 4, on prévoit d'alimenter le circuit 5H par une source de tension continue 81 référencée à la source SH du transistor HM. En d'autres termes, la borne la plus positive + de la source 81 est reliée, de préférence connectée, à la borne 75 d'alimentation positive du circuit 5H et la borne la plus négative - de la source 81 est reliée, de préférence connectée, à la source SH du transistor HM permettant ainsi de référencer son signal de commande de grille au potentiel flottant de la borne SH. La source de tension 81 est une source basse tension (de quelques volts) compatible avec la tension que peut supporter le circuit de commande 5H.

L'alimentation du circuit 5L est effectuée par un condensateur 89 dont les deux électrodes sont reliées, de préférence connectées, aux bornes d'alimentation du circuit 5L.

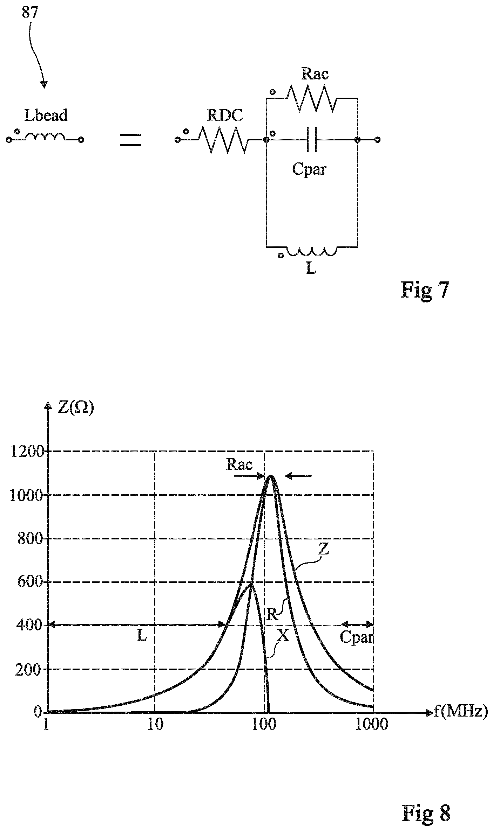

Le transfert d'énergie de la source de tension 81 au condensateur 89 s'effectue, selon les modes de réalisation décrits, par un montage Z8 dont l'impédance varie en fonction de la fréquence. Le rôle de ce montage est de transférer de l'énergie de la source de tension 81 vers le condensateur 89 avec une réponse en fréquence particulière de façon à bloquer les tensions induites par l'inductance Lss. Le montage Z8 relie la borne 75 à l'électrode négative du condensateur 89 (celle reliée, de préférence connectée, à une borne 77 d'application du potentiel le plus négatif de la tension d'alimentation du circuit 5L). Le montage Z8 comporte, en série entre les bornes 75 et 77, une perle de ferrite 87 (ferrite bead), une diode 83 et une résistance 85, la cathode de la diode 83 étant dirigée vers le condensateur 89 pour éviter sa décharge dans la source de tension 81. La diode 83 contribue à protéger la source de tension 81 en bloquant (au moins partiellement) les tensions négatives induites par l'inductance Lss. La résistance 85 permet d'éviter des surtensions au démarrage. En effet, comme cela ressortira mieux de l'exposé des figures 7 et 8, la perle de ferrite 87 se comporte comme une inductance aux basses fréquences. Sans la résistance 85, on risquerait d'induire des surtensions aux bornes du condensateur 89 qui pourraient l'endommager. La résistance 85 peut, le cas échéant, être apportée par la résistance dynamique de la diode 83, ce qui évite un composant.

Le choix d'une perle de ferrite tire son origine d'une nouvelle analyse du comportement des potentiels des sources respectives SH et SL des transistors HM et HL lors de commutations, en particulier lors des commutations pour rendre passants les transistors HM et HL. En effet, lors des commutations, l'inductance parasite Lss se comporte comme une source de courant et introduit une différence de potentiel entre les sources SH et SL. Ce phénomène est particulièrement présent dans les applications visées par la présente description où la vitesse de commutation est importante, par exemple de l'ordre de 2 à 10 A/ns en raison de la fréquence équivalente à laquelle les transistors HM et HL voient les variations de courant (de l'ordre de la centaine de MHz).

Le cas échéant, une ou plusieurs diodes Zener peuvent être connectées aux bornes du condensateur 89 afin de le protéger contre d'éventuelles surtensions. Le seuil de la ou des diodes Zener est alors choisi en fonction de la tension d'alimentation souhaitée pour le circuit 5L.

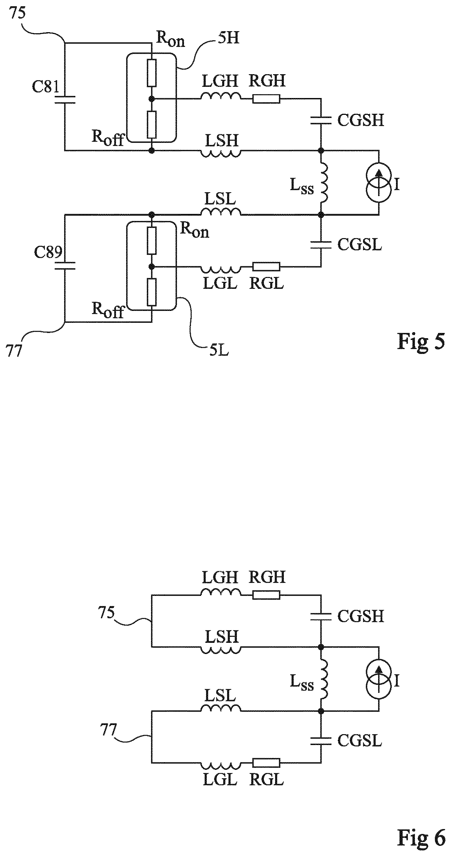

La figure 5 représente, de façon schématique et partielle, un modèle du montage de la figure 4.

La figure 6 représente, de façon schématique et partielle, un autre modèle du montage de la figure.

Les figures 5 et 6 représentent, de façon schématique, les modèles respectivement intermédiaire (figure 5) et en petits signaux (figure 6) du montage de la figure 4 sans l'inductance Z8.

En partant du schéma de la figure 4, on peut considérer (figure 5) que la source de tension 81 et le condensateur 89 sont respectivement équivalents à des capacités C81 et C89 en parallèle d'associations en série de résistances Ron et Roff représentant, pour chaque circuit de commande 5H, 5L, les résistances à l'état passant et à l'état bloqué de ses interrupteurs (SW, figure 3). Les points milieux des associations en série des résistances Ron et Roff sont reliés par des inductances parasites respectives LGH et LGL, en série avec des résistances de grille (intrinsèques) RGH, respectivement RGL, aux grilles des transistors HM et LM. Chaque transistor HM, LM peut être assimilé à une capacité grille-source CGSH, respectivement CGHL, entre la résistance RGH, respectivement RGL, et l'inductance parasite Lss reliant les sources ensemble. En outre, les capacités 81 et 89 sont respectivement reliées aux bornes de l'inductance Lss par des inductances LSH et LSV. Lors des commutations, cette inductance parasite Lss peut être considérée comme étant en parallèle avec une source de courant I dynamique liée à la commutation du courant de l'inductance.

Le schéma de la figure 5 peut se simplifier, en petits signaux, en un modèle (figure 6) dans lequel les électrodes de source des capacités CGSH et CGSL sont reliées par l'inductance Lss et la source de courant I en parallèle, et dans lequel chaque électrode de source est reliée à l'électrode de grille de la capacité CGSH, respectivement GGSL, concernée par l'association en série de l'inductance LSH, respectivement LSL, de l'inductance LGH, respectivement LGL, et de la résistance RGH, respectivement RGL.

On aurait pu penser relier directement ou via une diode les bornes 75 et 77 pour transférer de l'énergie vers le condensateur 89. Toutefois, lors d'une commutation, le comportement des grilles des transistors HM et LM peut être perturbé à un point tel, par exemple, de remettre le transistor LM en conduction alors qu'on souhaite le bloquer.

Le fait de prévoir une perle de ferrite 87 (figure 4) entre les bornes 75 et 77 permet, en la dimensionnant correctement, d'isoler les points 75 et 77 lors des commutations tout en autorisant le passage d'un courant de la borne 75 à la borne 77 hors des commutations pour fournir l'énergie requise au condensateur 89.

On tire pour cela profit de la réponse en fréquence d'une perle de ferrite qui se comporte comme une résistance autour de sa fréquence de résonance.

La figure 7 représente le schéma électrique équivalent d'une perle de ferrite.

Une perle de ferrite peut être symbolisée par une inductance Lbead. Cette inductance Lbead est en fait équivalente à une résistance Rdc en série avec une association en parallèle d'une inductance L, d'une capacité Cpar et d'une résistance Rac, dont les contributions sont différentes en fonction de la fréquence. En particulier, le comportement de la perle de ferrite est différent en fonction de la fréquence par rapport à la fréquence de résonance conditionnée par l'inductance L et la capacité Cpar.

Une perle de ferrite est un élément assurant une fonction de filtrage, ce qui la différencie d'un élément inductif de stockage. Une perle de ferrite est habituellement utilisée pour réduire (filtrer) les parasites électromagnétiques hautes fréquences (supérieurs à la dizaine, voire centaine de MHz) sur des câbles. On tire profit, dans les modes de réalisation décrits, de cette fonction de filtrage d'une perle de ferrite.

La figure 8 illustre la réponse en fréquence d'un exemple de perle de ferrite.

La figure 8 représente un exemple d'allure de l'impédance (en ohms) apportée par la perle de ferrite 87 en fonction de la fréquence f (en MHz). Trois courbes R, X et Z sont présentes en figure 8, les courbes X et R représentant respectivement les parties réelle et imaginaire de l'impédance illustrée par la courbe Z.

Le comportement (en impédance) d'une perle de ferrite en fonction de la fréquence peut se résumer de la façon suivante :
- autour de sa fréquence de résonance, elle se comporte comme une résistance de forte valeur (dans l'exemple représenté de l'ordre du kilo-ohms), conditionnée principalement par la valeur de résistance équivalente en petits signaux Rac ;
- avant la résonance (pour des fréquences inférieures à la fréquence de résonance), elle se comporte principalement comme un élément inductif de valeur L ; et
- après la résonance (pour des fréquences supérieures à la fréquence de résonance), elle se comporte principalement comme un élément capacitif de valeur Cpar.

On voit donc qu'en choisissant une perle de ferrite ayant une fréquence de résonance proche de la fréquence équivalente des fronts de courant circulant dans les transistors HM et LM, celle-ci isole fictivement les bornes 75 et 77 par son comportement fortement résistif et attenue donc l'effet induit par les surtensions aux bornes de l'inductance parasite Lss lors des commutations. Toutefois, grâce au comportement inductif à basse fréquence, la perle de ferrite n'empêche pas le transfert d'énergie de la borne 75 vers la borne 77 entre les commutations.

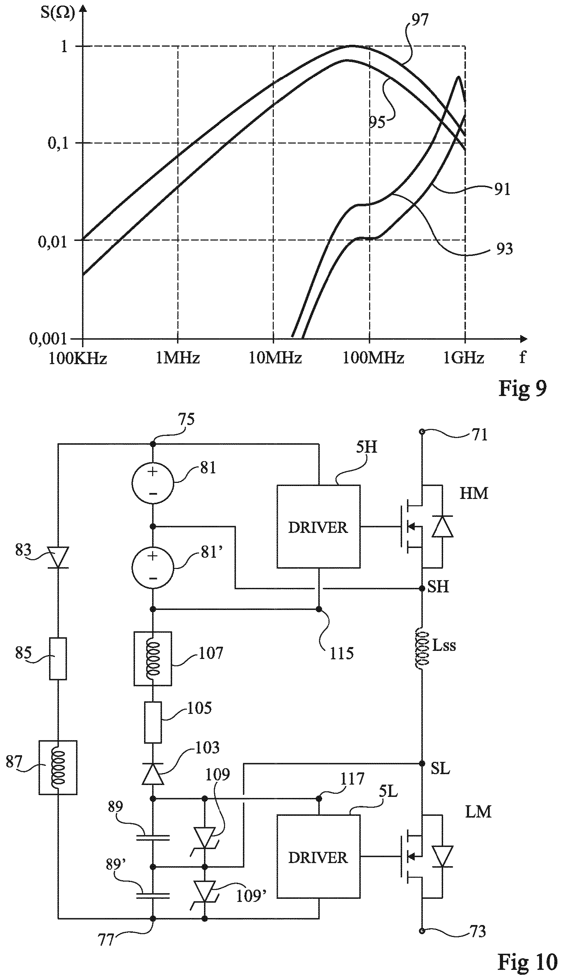

La figure 9 illustre la susceptibilité de la tension de commande d'un transistor du circuit de la figure 4.

Plus précisément, la figure 9 représente, à titre d'exemple, l'évolution de la susceptibilité électrique de la tension grille-source d'un transistor d'un circuit réalisé selon la figure 4 et d'un circuit dans lequel les bornes 75 et 77 sont directement reliées, en fonction de la fréquence de perturbations apportées par l'inductance parasite Lss de connexion des sources SH et SL. La susceptibilité S et la fréquence f sont en échelles logarithmiques. Deux courbes 91 et 93 illustrent la susceptibilité du circuit de la figure 4 pour une inductance parasite Lss respectivement de l'ordre de 15 nH (courbe 91) et de l'ordre de 30 nH (courbe 93). Deux courbes 95 et 97 illustrent la susceptibilité en fréquence du circuit avec une connexion directe entre les bornes 75 et 77 et une inductance parasite Lss respectivement de l'ordre de 15 nH (courbe 95) et de l'ordre de 30 nH (courbe 97).

Comme il ressort de ces courbes, en l'absence de perle de ferrite, à des fréquences de l'ordre de 100 MHz, les oscillations sur la grille entraîneraient des destructions des grilles et/ou des remises en conduction parasites. En effet, la sensibilité de l'ordre de l'ohm entraîne une tension de plusieurs volts sous l'effet de courants parasites de plusieurs ampères. Avec la perle de ferrite 87, la susceptibilité n'est que de l'ordre de la centaine de milliohms, ce qui limite l'impact sur les grilles à des tensions de l'ordre de la centaine de millivolts, insuffisantes pour remettre un transistor en conduction.

On aurait pu penser relier les bornes 75 et 77 par une résistance en série avec une diode pour transposer la solution de la figure 3. Toutefois, la valeur de la résistance qu'il faudrait alors prévoir (de l'ordre de la centaine d'ohms) introduirait en permanence une différence de potentiel trop importante entre les bornes 75 et 77. Grâce à la perle de ferrite, on peut prévoir une résistance 85 de faible valeur (quelques ohms) en régime permanent, tout en disposant d'une résistance de l'ordre du kilo-ohms lors des commutations.

On notera que, dans les modes de réalisation décrits, la perle de ferrite est placée, par rapport aux grilles des transistors, en amont des circuits 5H et 5L de commande de grille.

Le choix de la perle de ferrite dépend de l'application et des caractéristiques du montage.

La détermination peut être effectuée de façon empirique en essayant différentes perles de ferrite. Toutefois, de préférence, on évalue plutôt certaines caractéristiques du montage afin de faciliter le choix de la perle de ferrite.

En particulier, une estimation des fronts de commutation (dI/dt) fournit une approximation de la résonance souhaitée pour la ferrite. Ce dI/dt peut être déduit de données caractéristiques des transistors et des circuits de commande telles que les temps de montée et temps de descente. La plage disponible de valeurs de fréquence de résonance des perles de ferrite (qui s'étend d'environ 10 MHz à environ 1 GHz) offre suffisamment de choix en fonction des contraintes propres au circuit.

Outre les avantages de fournir une alimentation des deux circuits 5H et 5L à partir d'une seule source de tension et sans isolation galvanique, un avantage induit par le montage décrit est qu'il permet d'amortir les oscillations de courant drain-source lors des commutations. Cela réduit les oscillations au niveau des tensions grille-source et drain-source des transistors. Cela contribue à l'amélioration de la réponse face à des perturbations électromagnétiques et permet d'éviter l'emploi de circuits dédiés.

La figure 10 représente un autre mode de réalisation d'un montage d'alimentation de circuits de commande de deux transistors en série, appliqué à une alimentation à double polarité (positive et négative).

Par rapport au montage de la figure 4, le circuit 5H est alimenté par une tension fournie par deux sources de tensions 81 et 81' en série entre des bornes 75 et 115 d'alimentation du circuit 5H. Le point milieu de cette association en série est relié, de préférence connecté, à la source SH du transistor HM. Côté transistor LM, sa source est reliée, de préférence connectée au point milieu d'une association en série de deux condensateurs 89 et 89' entre des bornes 117 et 77 d'alimentation du circuit 5L. Le point milieu de cette association en série est relié, de préférence connecté, à la source SL du transistor LM. Chaque condensateur 89, 89' est en parallèle avec une diode Zener 109, respectivement 109', fixant la tension à ses bornes, en cas de surtensions.

Un premier montage Bootstrap, constitué d'une diode 83, d'une résistance 85 et d'une perle en ferrite 87 (symbolisée ici par un élément inductif), relie les bornes 75 et 77 comme en figure 4, l'anode de la diode 83 étant côté borne 75. Un deuxième montage Bootstrap, constitué d'une diode 103, d'une résistance 105 et d'une perle en ferrite 107, relie les bornes 115 et 117, l'anode de la diode 103 étant côté borne 117.

Le fonctionnement et le dimensionnement du montage de la figure 10 se déduisent du fonctionnement et du dimensionnement exposés en relation avec le mode de réalisation de la figure 4.

Les modes de réalisation décrits se transposent sans difficulté à l'alimentation de circuits de commande d'un onduleur de tension dans lequel certains commutateurs comportent des transistors à sources communes qui doivent être commandés en conduction alternée.

Plus généralement, les modes de réalisation décrits se transposent à tout montage d'alimentation, par une seule source de tension, de deux circuits de commande de grille de transistors en série entre deux bornes dont au moins une est à un potentiel flottant.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art. En particulier, bien que les modes de réalisation aient été décrits en relation avec des transistors MOS à canal N, représentés sous la forme de transistors à enrichissement, ils se transposent sans difficulté à l'utilisation de transistors MOS à appauvrissement ou de transistors à canal P à drains communs. De même, les modes de réalisation décrits se transposent à l'utilisation de n'importe quel type d'interrupteurs à commande en tension, par exemple de type transistor bipolaire à grille isolée (IGBT), montés tête-bêche (à émetteurs communs ou à collecteurs communs).

Enfin, la mise en oeuvre pratique des modes de réalisation et variantes décrits est à la portée de l'homme du métier à partir des indications fonctionnelles données ci-dessus, en particulier pour ce qui est de la sélection de la perle de ferrite et du dimensionnement des autres composants du circuit en fonction de l'application.

## Revendications

1. Circuit de fourniture de tensions d'alimentation à un premier circuit (5H) de commande d'un premier interrupteur et à un deuxième circuit (5L) de commande d'un deuxième interrupteur (LM), les premier et deuxième interrupteurs étant montés en série, comportant :
une première source de tension (81) destinée à alimenter le premier circuit (5H), entre une première borne (75) d'application d'une première tension et une borne de conduction (SH) du premier interrupteur reliées à une borne de conduction (SL) du deuxième interrupteur ;
au moins un condensateur (89) pour alimenter le deuxième circuit (5L) ; et
un montage comprenant au moins une perle de ferrite (87) en série avec une diode (83) et une résistance (85) entre ladite une première borne (75) et une première borne (77) dudit deuxième circuit.

2. Circuit selon la revendication 1, dans lequel la perle de ferrite (87) assure une fonction de filtrage à des fréquences supérieures à 10 MHz, de préférence supérieures à 100 MHz.

3. Circuit selon la revendication 1 ou 2, dans lequel au moins un condensateur (89) relie ladite première borne (77) du deuxième circuit (5L) à une deuxième borne de ce deuxième circuit.

4. Circuit selon l'une quelconque des revendications 1 à 3, dans lequel la première tension est fournie par une source de tension (81).

5. Circuit selon l'une quelconque des revendications 1 à 4, constituant un montage Bootstrap.

6. Circuit selon l'une quelconque des revendications 1 à 5, dans lequel une deuxième borne de la source de tension (81) est reliée, de préférence connectée, à une deuxième borne du premier circuit (5H).

7. Circuit selon la revendication 6, dans lequel le premier circuit (5H) et le deuxième circuit (5L) sont des circuits de commande respectifs d'un premier interrupteur (HM) et d'un deuxième interrupteur (LM) en série, les deuxièmes bornes respectives du premier circuit (5H) et du deuxième circuit (5L) étant reliées, de préférence connectées, à des bornes de conduction respectives (SH, SL) du premier interrupteur (HM) et du deuxième interrupteur (LM).

8. Circuit selon la revendication 7, dans lequel ladite perle de ferrite (87) est choisie pour avoir une fréquence de résonance du même ordre de grandeur que la fréquence de commutation des premier et deuxième interrupteurs (HM, LM).

9. Circuit selon l'une quelconque des revendications 1 à 8, dans lequel les interrupteurs (LM, HM) sont des interrupteurs à commande en tension.

10. Circuit selon la revendication 9, dans lequel les interrupteurs (LM, HM) sont des transistors MOS à canal N montés en sources communes.

11. Commutateur comportant un circuit selon l'une quelconque des revendications 1 à 10.

12. Commutateur selon la revendication 11, comportant en outre :
une deuxième source de tension (81') en série avec la première source de tension, le premier circuit de commande (5H) étant alimenté par les deux sources de tension (81, 81') en série ; et
un deuxième montage selon l'une quelconque des revendications 1 à 5, entre une borne de la deuxième source de tension et une borne (107), du deuxième circuit de commande (5L).

13. Onduleur de courant comportant six commutateurs (31, 32, 33, 34, 35, 36) selon la revendication 11 ou 12, reliés en série par paire de commutateurs, les paires de commutateurs étant en parallèle entre deux bornes (21, 23) d'entrée de l'onduleur.

14. Onduleur de tension comportant des commutateurs selon la revendication 11 ou 12.

## Patentansprüche

1. Schaltung zum Vorsehen von Versorgungsspannungen an eine erste Schaltung (5H) zum Steuern eines ersten Schalters und an eine zweite Schaltung (5L) zum Steuern eines zweiten Schalters (LM), wobei der erste und der zweite Schalter in Reihe geschaltet sind, aufweisend:
eine erste Spannungsquelle (81), die dazu bestimmt ist, die erste Schaltung (5H) zu versorgen, zwischen einem ersten Anschluss (75) zum Anlegen einer ersten Spannung und einem leitenden Anschluss (SH) des ersten Schalters, der mit einem leitenden Anschluss (SL) des zweiten Schalters verbunden ist;
mindestens einem Kondensator (89) für die Stromversorgung der zweiten Schaltung (5L); und
eine Anordnung mit mindestens einer Ferritperle (87) in Reihe mit einer Diode (83) und einem Widerstand (85) zwischen dem ersten Anschluss (75) und einem ersten Anschluss (77) der zweiten Schaltung.

2. Schaltung nach Anspruch 1, wobei die Ferritperle (87) eine Filterfunktion bei Frequenzen von mehr als 10 MHz, vorzugsweise mehr als 100 MHz, vorsieht.

3. Schaltung nach Anspruch 1 oder 2, bei der mindestens ein Kondensator (89) den ersten Anschluss (77) der zweiten Schaltung (5L) mit einem zweiten Anschluss dieser ersten Schaltung koppelt.

4. Schaltung nach einem der Ansprüche 1 bis 3, wobei die erste Spannung von einer Spannungsquelle (81) geliefert wird.

5. Schaltung nach einem der Ansprüche 1 bis 4, die eine Bootstrap-Baugruppe bildet.

6. Schaltung nach einem der Ansprüche 1 bis 5, wobei ein zweiter Anschluss der Spannungsquelle (81) mit einem zweiten Anschluss der ersten Schaltung (5H) gekoppelt, vorzugsweise verbunden, ist.

7. Schaltung nach Anspruch 6, wobei die erste Schaltung (5H) und die zweite Schaltung (5L) jeweilige Steuerschaltungen eines ersten Schalters (HM) und eines zweiten Schalters (LM) in Reihe sind, wobei die zweiten jeweiligen Anschlüsse der ersten Schaltung (5H) und der zweiten Schaltung (5L) mit jeweiligen Leitungsanschlüssen (SH, SL) des ersten Schalters (HM) und des zweiten Schalters (LM) gekoppelt, vorzugsweise verbunden, sind.

8. Schaltung nach Anspruch 7, wobei die Ferritperle (87) so ausgewählt ist, dass sie eine Resonanzfrequenz in der gleichen Größenordnung wie die Schaltfrequenz des ersten und des zweiten Schalters (HM, LM) aufweist.

9. Schaltung nach einem der Ansprüche 1 bis 8, wobei die Schalter (LM, HM) spannungsgesteuerte Schalter sind.

10. Schaltung nach Anspruch 9, wobei die Schalter (LM, HM) N-Kanal-MOS-Transistoren sind, die mit einer gemeinsamen Source verbunden sind.

11. Schalter mit einer Schaltung nach einem der Ansprüche 1 bis 10.

12. Schalter nach Anspruch 11, ferner aufweisend:
eine zweite Spannungsquelle (81') in Reihe mit der ersten Spannungsquelle, wobei die erste Steuerschaltung (5H) von den beiden Spannungsquellen (81, 81') in Reihe gespeist wird; und
eine zweite Baugruppe nach einem der Ansprüche 1 bis 5 zwischen einem Anschluss der zweiten Spannungsquelle und einem Anschluss (107) der zweiten Steuerschaltung (5L).

13. Stromwechselrichter mit sechs Schaltern (31, 32, 33, 34, 35, 36) nach Anspruch 11 oder 12, die in Schalterpaaren in Reihe geschaltet sind, wobei die Schalterpaare zwischen zwei Eingangsanschlüssen (21, 23) des Wechselrichters parallel geschaltet sind.

14. Spannungswechselrichter mit Schaltern nach Anspruch 11 oder 12.

## Claims

1. Circuit for providing power supply voltages to a first circuit (5H) for controlling a first switch and to a second circuit (5L) for controlling a second switch (LM), the first and second switches being serially mounted, including:
a first voltage source (81) intended to power the first circuit (5H), between a first terminal (75) for applying a first voltage and a conducting terminal (SH) of the first switch coupled to a conducting terminal (SL) of the second switch;
at least one capacitor (89) for power supplying the second circuit (5L); and
an assembly comprising at least one ferrite bead (87) in series with a diode (83) and a resistor (85) between said first terminal (75) and a first terminal (77) of said second circuit.

2. Circuit according to claim 1, wherein the ferrite bead (87) provides a filtering function at frequencies greater than 10 MHz, preferably greater than 100 MHz.

3. Circuit according to claim 1 or 2, wherein at least one capacitor (89) couples said first terminal (77) of the second circuit (5L) to a second terminal of this first circuit.

4. Circuit according to any one of claims 1 to 3, wherein the first voltage is supplied by a voltage source (81).

5. Circuit according to any one of claims 1 to 4, forming a bootstrap assembly.

6. Circuit according to any one of claims 1 to 5, wherein a second terminal of the voltage source (81) is coupled, preferably connected, to a second terminal of the first circuit (5H).

7. Circuit according to claim 6, wherein the first circuit (5H) and the second circuit (5L) are respective control circuits of a first switch (HM) and of a second switch (LM) in series, the second respective terminals of the first circuit (5H) and of the second circuit (5L) being coupled, preferably connected, to respective conduction terminals (SH, SL) of the first switch (HM) and of the second switch (LM).

8. Circuit according to claim 7, wherein said ferrite bead (87) is selected to have a resonance frequency of the same order of magnitude as the switching frequency of the first and second switches (HM, LM).

9. Circuit according to any one of claims 1 to 8, wherein the switches (LM, HM) are voltage-controlled switches.

10. Circuit according to claim 9, wherein the switches (LM, HM) are N-channel MOS transistors assembled with a common source.

11. Switch including a circuit according to any one of claims 1 to 10.

12. Switch according to claim 11, further including:
a second voltage source (81') in series with the first voltage source, the first control circuit (5H) being powered by the two voltage sources (81, 81') in series; and
a second assembly according to any one of claims 1 to 5, between a terminal of the second voltage source and a terminal (107) of the second control circuit (5L).

13. Current inverter including six switches (31, 32, 33, 34, 35, 36) according to claim 11 or 12, series-coupled in pairs of switches, the pairs of switches being in parallel between two input terminals (21, 23) of the inverter.

14. Voltage inverter comprising switches according to claim 11 or 12.
